# EUROPÄISCHE PATENTANMELDUNG

(11) **EP 3 300 201 A1**
(43) Veröffentlichungstag der Anmeldung: **28.03.2018**
(21) Anmeldenummer: 16190346.3
(22) Anmeldetag: 23.09.2016
(51) Int. Cl.: H02H 3/17, H02H 5/10, H02H 7/26, G01R 31/08

(54) **VERFAHREN UND EINRICHTUNG ZUM ÜBERWACHEN EINER ENERGIEÜBERTRAGUNGSEINRICHTUNG**

(71) Anmelder: Siemens Aktiengesellschaft, 80333 München (DE)
(72) Erfinder: Englert, Heiko, 90559 Burgthann (DE); Kussyk, Jaroslaw, 1170 Wien (AT)

(57) **Zusammenfassung**

Die Erfindung bezieht sich u. a. auf ein Verfahren zum Überwachen einer Energieübertragungseinrichtung, insbesondere einer Energieübertragungsleitung (14) oder eines Energieverteilnetzes (10), über die oder das elektrischer Strom mit einer vorgegebenen Netzfrequenz übertragen wird.

Erfindungsgemäß ist vorgesehen, dass ein elektrisches Messsignal (S) mit zumindest einer nicht-netzfrequenten Frequenz, also einer Frequenz, die sich von der Netzfrequenz unterscheidet, oder einem nicht-netzfrequenten Frequenzband an einer vorgegebenen Stelle (P1-P4) der Energieübertragungseinrichtung in diese eingespeist wird, an der vorgegebenen Stelle (P1-P4) oder einer anderen Stelle (P1-P4) der Energieübertragungseinrichtung eine auf die nicht-netzfrequente Frequenz oder das nicht-netzfrequente Frequenzband bezogene elektrische Messgröße (M) unter Bildung zumindest eines Messwerts oder frequenzbandbezogenen Messwertverlaufs gemessen wird und ein Fehlersignal (F) erzeugt wird, wenn der Messwert, der frequenzbandbezogene Messwertverlauf, ein mit dem Messwert oder dem Messwertverlauf gebildeter Vergleichswert oder Vergleichswertverlauf auf einen Fehler in der Energieübertragungseinrichtung hindeutet.

## Beschreibung

Die Erfindung bezieht sich auf ein Verfahren zum Überwachen einer Energieübertragungseinrichtung, insbesondere einer Energieübertragungsleitung oder eines Energieverteilnetzes, über die oder das elektrischer Strom mit einer vorgegebenen Netzfrequenz übertragen wird.

Im Falle eines Leiterbruchs einer Energieübertragungsleitung oder eines Phasenleiters der Energieübertragungsleitung und im Falle eines nachfolgenden Herunterfallens eines Leitungsendes auf den Boden können, insbesondere bei hohem Erdwiderstand, sehr hochohmige Fehler auftreten. Insbesondere in Mittelspannungsnetzen mit starrer Sternpunkterdung stellen hochohmige Fehler ein großes Problem dar, weil diese Fehler schwer zu erkennen sind und die nach Fehlereintritt ggf. noch anliegende hohe Berührungsspannung Personen gefährden kann. In Nordamerika und in Teilen von Afrika, in denen starr geerdete Mittelspannungsnetze vorwiegend in Form von Freileitungen üblich sind, ereignen sich jährlich zahlreiche Unfälle mit Todesfolge durch solche hochohmigen Fehler.

Die Erkennung der hochohmigen Fehler wird insbesondere durch folgende Faktoren erschwert:
- Die Fehlerströme sind in ihrer Höhe schwer von den Betriebsströmen/Lastströmen im fehlerfreien Fall zu unterscheiden.
- Durch die starre Sternpunkterdung des Einspeisetransformators in das Mittelspannungsnetz resultiert im einpoligen Fehlerfall keine Spannungsverlagerung, die durch ein Spannungsrelais, wie sie bei kompensierten Netzen in Europa im Einsatz sind, detektiert werden könnte.
- Im Betrieb werden die Netze im Allgemeinen unsymmetrisch belastet; folglich eignet sich der Reststrom über den Transformatorsternpunkt eines das Mittelspannungsnetz speisenden Transformators als Erkennungskriterium im Allgemeinen nicht.

Der Erfindung liegt die Aufgabe zugrunde, ein Verfahren zum Überwachen einer Energieübertragungseinrichtung anzugeben, das eine zuverlässige Fehlererkennung ermöglicht, insbesondere für solche mit starrer Sternpunkterdung.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass ein elektrisches Messsignal mit zumindest einer nicht-netzfrequenten Frequenz, also einer Frequenz, die sich von der Netzfrequenz unterscheidet, oder einem nicht-netzfrequenten Frequenzband an einer vorgegebenen Stelle der Energieübertragungseinrichtung in diese eingespeist wird, an der vorgegebenen Stelle oder einer anderen Stelle der Energieübertragungseinrichtung eine auf die nicht-netzfrequente Frequenz oder das nicht-netzfrequente Frequenzband bezogene elektrische Messgröße unter Bildung zumindest eines Messwerts oder frequenzbandbezogenen Messwertverlaufs gemessen wird und ein Fehlersignal erzeugt wird, wenn der Messwert, der frequenzbandbezogene Messwertverlauf, ein mit dem Messwert oder dem Messwertverlauf gebildeter Vergleichswert oder Vergleichswertverlauf auf einen Fehler in der Energieübertragungseinrichtung hindeutet.

Ein wesentlicher Vorteil des erfindungsgemäßen Verfahrens besteht darin, dass durch das erfindungsgemäß vorgesehene, gezielte Einspeisen von Messsignalen mit nicht-netzfrequenter Frequenz bzw. mit einem nicht-netzfrequenten Frequenzband auch hochohmige Fehler mit starrer Sternpunkterdung sicher detektiert werden können, weil sich hochohmige Fehler bei anderen Frequenzen als der Netzfrequenz - wie erfinderseitig festgestellt wurde - signifikanter bemerkbar machen können als bei der Netzfrequenz.

Besonders einfach und damit vorteilhaft lässt sich das Verfahren durchführen, wenn der Messwert oder der frequenzbandbezogene Messwertverlauf unter Bildung eines Referenzwertes oder Referenzverlaufs zu einem Zeitpunkt erfasst wird, der als fehlerfrei angenommen wird. Ein Fehlersignal wird vorzugsweise erzeugt, wenn der aktuelle Messwert oder der aktuelle frequenzbandbezogene Messwertverlauf und/oder ein mit dem aktuellen Messwert oder dem aktuellen frequenzbandbezogenen Messwertverlauf gebildeter aktueller Vergleichswert oder aktueller Vergleichswertverlauf über ein vorgegebenes Maß vom Referenzwert oder Referenzverlauf abweicht.

Bei einer bevorzugten Ausführungsvariante ist vorgesehen, dass an der vorgegebenen Stelle als elektrisches Messsignal eine elektrische Spannung mit nicht-netzfrequenter Frequenz eingespeist wird und an derselben Stelle als die nicht-netzfrequente Messgröße der Strom nach Betrag und/oder Phase gemessen wird.

Alternativ oder zusätzlich kann im Rahmen einer weiteren vorteilhaften Ausgestaltung des Verfahrens vorgesehen sein, dass das Messsignal an einer vorgegebenen Stelle, nachfolgend erste Stelle genannt, der Energieübertragungseinrichtung eingespeist wird und an einer anderen Stelle, nachfolgend zweite Stelle genannt, der Energieübertragungseinrichtung der Messwert oder Messwertverlauf gemessen wird.

Als Referenzwert oder Referenzverlauf kann in vorteilhafter Weise die Leitungsimpedanz, der Leitungsimpedanzverlauf, der Wellenwiderstand, der Wellenwiderstandsverlauf in dem Frequenzband, die Dämpfung der Energieübertragungseinrichtung oder der Dämpfungsverlauf der Energieübertragungseinrichtung in dem Frequenzband gebildet werden. Bei dieser Ausgestaltung ist es vorteilhaft, wenn mit dem aktuellen Messwert oder dem aktuellen frequenzbandbezogenen Messwertverlauf (als Vergleichswert oder Vergleichswertverlauf) die aktuelle Leitungsimpedanz, der aktuelle Leitungsimpedanzverlauf, der aktuelle Wellenwiderstand, der aktuelle Wellenwiderstandsverlauf in dem Frequenzband, die aktuelle Dämpfung der Energieübertragungseinrichtung und/oder der Dämpfungsverlauf der Energieübertragungseinrichtung in dem Frequenzband ermittelt wird. Die letztgenannte Variante ist mit Blick auf eine Auswertung bezüglich Wellenwiderstand und/oder Dämpfung besonders einfach durchführbar, wenn das Einspeisen und Messen an unterschiedlichen Stellen erfolgt.

Bezüglich der Auswertung der Messwerte wird es als vorteilhaft angesehen, wenn während der Messung die Frequenz der Spannung innerhalb eines vorgegebenen nicht-netzfrequenten Frequenzbands durchfahren wird und der Strom nach Betrag und/oder Phase für das Frequenzband gemessen wird.

Vorzugsweise stehen eine erste und eine zweite Überwachungseinrichtung in einer Kommunikationsverbindung, die insbesondere auf über die Energieübertragungseinrichtung übermittelten nicht-netzfrequenten Kommunikationssignalen oder den Messsignalen selbst (sofern sie zusätzlich als Kommunikationssignale verwendet werden) beruht. Das Einspeisen des Messsignals und das Erfassen des Messwerts oder Messwertverlaufs wird bevorzugt über die Kommunikationsverbindung synchronisiert.

Besonders vorteilhaft ist es, wenn der Messwert, Messwertverlauf, Vergleichswert oder Vergleichswertverlauf von der zweiten Überwachungseinrichtung zu der ersten Überwachungseinrichtung übertragen wird, insbesondere über die Energieübertragungseinrichtung mittels eines nicht-netzfrequenten Kommunikationssignals, und die erste Überwachungseinrichtung das Fehlersignal erzeugt, wenn der Messwert, Messwertverlauf aktuelle Vergleichswert oder aktuelle Vergleichswertverlauf auf einen Fehler in der Energieübertragungseinrichtung hindeutet.

Mit Blick auf eine besonders zuverlässige, insbesondere netzweite, Überwachung wird es als vorteilhaft angesehen, wenn an die Energieübertragungseinrichtung an verschiedenen Stellen zwei oder mehr Überwachungseinrichtungen angeschlossen sind, mit denen jeweils nicht-netzfrequente Messsignale in die Energieübertragungseinrichtung eingespeist und/oder nicht-netzfrequente Messwerte oder Messwertverläufe erfasst werden und/oder aktuelle Vergleichswerte oder aktuelle Vergleichswertverläufe gebildet werden und/oder überwachungseinrichtungsindividuell Hilfsfehlersignale erzeugt werden. Die Messwerte, die Messwertverläufe, die aktuellen Vergleichswerte, die aktuellen Vergleichswertverläufe und/oder die überwachungseinrichtungsindividuell erzeugten Hilfsfehlersignale werden bevorzugt zu einer zentralen Schutzeinrichtung übertragen. Die zentrale Schutzeinrichtung erzeugt vorzugsweise das Fehlersignal, wenn einer oder mehrere der Messwerte oder einer oder mehrere der Messwertverläufe oder einer oder mehrere der aktuellen Vergleichswerte oder einer oder mehrere der aktuellen Vergleichswertverläufe auf einen Fehler in der Energieübertragungseinrichtung hindeuten.

Die nicht-netzfrequente Frequenz des elektrischen Messsignals oder das nicht-netzfrequente Frequenzband liegt vorzugsweise in einem Frequenzbereich zwischen 30 kHz und 30 MHz, insbesondere zwischen 100 kHz und 500 kHz.

Mit dem Verfahren wird vorzugsweise ein Spannungsnetz, insbesondere ein Mittelspannungsnetz, mit starrer Sternpunkterdung überwacht. Unter einem Mittelspannungsnetz wird hier ein Netz mit einer Netzspannung zwischen 1 kV und 60 kV verstanden.

Die Erfindung bezieht sich darüber hinaus auf eine Überwachungseinrichtung zum Überwachen einer Energieübertragungseinrichtung, insbesondere einer Energieübertragungsleitung oder eines Energieverteilnetzes, über die elektrischer Strom mit einer vorgegebenen Netzfrequenz übertragen wird.

Bezüglich einer solchen Überwachungseinrichtung ist erfindungsgemäß vorgesehen, dass die Überwachungseinrichtung eine Messeinrichtung aufweist, die eine auf eine nicht-netzfrequente Frequenz oder ein nicht-netzfrequentes Frequenzband bezogene elektrische Messgröße unter Bildung zumindest eines Messwerts oder frequenzbandbezogenen Messwertverlaufs messen kann, und die Überwachungseinrichtung eine Auswerteinrichtung aufweist, die ein Fehlersignal erzeugt, wenn der Messwert, der frequenzbandbezogene Messwertverlauf, ein mit dem Messwert oder dem Messwertverlauf gebildeter Vergleichswert oder Vergleichswertverlauf auf einen Fehler in der Energieübertragungseinrichtung hindeutet.

Bezüglich der Vorteile der erfindungsgemäßen Überwachungseinrichtung sei auf die obigen Ausführungen im Zusammenhang mit dem erfindungsgemäßen Verfahren verwiesen.

Vorzugsweise weist die Überwachungseinrichtung zusätzlich eine Messsignalerzeugungseinheit auf, die ein elektrisches Messsignal mit zumindest einer nicht-netzfrequenten Frequenz, also einer Frequenz, die sich von der Netzfrequenz unterscheidet, oder einem nicht-netzfrequenten Frequenzband an einer vorgegebenen Stelle der Energieübertragungseinrichtung in diese einspeisen kann.

Vorzugsweise weist die Überwachungseinrichtung außerdem eine Kommunikationseinrichtung auf, die Messwerte, Messwertverläufe, mit diesen gebildete aktuelle Vergleichswerte, aktuelle Vergleichswertverläufe oder überwachungseinrichtungsindividuell erzeugte Hilfsfehlersignale an eine oder mehrere andere Überwachungseinrichtungen oder eine zentrale Schutzeinrichtung übermitteln kann. Auch ist es möglich, dass die Messsignale in Form von Kommunikationssignalen erzeugt werden, also die Messsignale selbst Kommunikationssignale bilden; in einem solchen Falle können die Messsignalerzeugungseinheit und die Kommunikationseinrichtung durch ein und dieselbe Einheit bzw. Einrichtung gebildet werden.

Die Erfindung bezieht sich darüber hinaus auf eine Überwachungsanordnung zum Überwachen einer Energieübertragungseinrichtung, insbesondere einer Energieübertragungsleitung oder eines Energieverteilnetzes, über die elektrischer Strom mit einer vorgegebenen Netzfrequenz übertragen wird.

Bezüglich einer solchen Überwachungsanordnung ist erfindungsgemäß vorgesehen, dass diese zumindest eine Überwachungseinrichtung , wie sie oben beschrieben worden ist, und zumindest eine Messsignalerzeugungseinheit aufweist, die ein elektrisches Messsignal mit zumindest einer nicht-netzfrequenten Frequenz, also einer Frequenz, die sich von der Netzfrequenz unterscheidet, oder einem nicht-netzfrequenten Frequenzband in die Energieübertragungseinrichtung einspeisen kann.

Die Messsignalerzeugungseinheit wird vorzugsweise durch einen Bestandteil der genannten Überwachungseinrichtung oder einen Bestandteil einer anderen, an einer anderen Stelle der Energieübertragungseinrichtung angeordneten, Überwachungseinrichtung gebildet.

Als besonders vorteilhaft wird es angesehen, wenn die Überwachungsanordnung eine zentrale Schutzeinrichtung aufweist, mit der die zumindest eine Überwachungseinrichtung in Verbindung steht und zu der die Messwerte oder Messwertverläufe, mit diesen gebildete aktuelle Vergleichswerte, aktuelle Vergleichswertverläufe oder überwachungseinrichtungsindividuell erzeugte Hilfsfehlersignale übertragen werden, und die zentrale Schutzeinrichtung derart ausgestaltet ist, dass sie das Fehlersignal erzeugt, wenn einer oder mehrere der Messwerte oder einer oder mehrere der Messwertverläufe oder einer oder mehrere der aktuellen Vergleichswerte oder einer oder mehrere der aktuellen Vergleichswertverläufe auf einen Fehler in der Energieübertragungseinrichtung hindeuten oder ein überwachungseinrichtungsindividuell erzeugtes Hilfsfehlersignal empfangen wird.

Die Erfindung bezieht sich außerdem auf eine Energieübertragungseinrichtung.

Erfindungsgemäß ist vorgesehen, dass an die Energieübertragungseinrichtung zumindest eine Überwachungseinrichtung wie oben beschrieben und/oder eine Überwachungsanordnung wie oben beschrieben angeschlossen ist. Die Energieübertragungseinrichtung wird mit der Überwachungseinrichtung und/oder der Überwachungsanordnung vorzugsweise nach einem Verfahren wie oben beschrieben überwacht.

Die Energieübertragungseinrichtung ist vorzugsweise ein Mittelspannungsnetz mit starrer Sternpunkterdung, ein Mittelspannungsbereich eines Energieverteilnetzes mit starrer Sternpunkterdung oder eine Mittelspannungsenergieübertragungsleitung mit starrer Sternpunkterdung.

Die Erfindung wird nachfolgend anhand von Ausführungsbeispielen näher erläutert; dabei zeigen beispielhaft
- Figur 1: ein Ausführungsbeispiel für eine erfindungsgemäße Überwachungsanordnung, anhand derer beispielhaft auch ein Ausführungsbeispiel für das erfindungsgemäße Verfahren erläutert wird,
- Figur 2: einen Referenzverlauf, anhand dessen eine Prüfung vorgenommen werden kann, ob ein Fehler vorliegt und ein Fehlersignal zu erzeugen ist,
- Figur 3: anhand der Überwachungsanordnung gemäß Figur 1 eine andere Variante für einen Betrieb von Überwachungseinrichtungen der Überwachungsanordnung,
- Figur 4: einen Abschnitt einer Energieübertragungsleitung eines Energieverteilnetzes, das von der Überwachungsanordnung gemäß Figur 1 überwacht wird, im Falle eines hochohmigen Fehlers einer Phasenleitung der Energieübertragungsleitung, und
- Figur 5: ein Ausführungsbeispiel für eine erfindungsgemäße Überwachungseinrichtung näher im Detail.

In den Figuren werden der Übersicht halber für identische oder vergleichbare Komponenten stets dieselben Bezugszeichen verwendet.

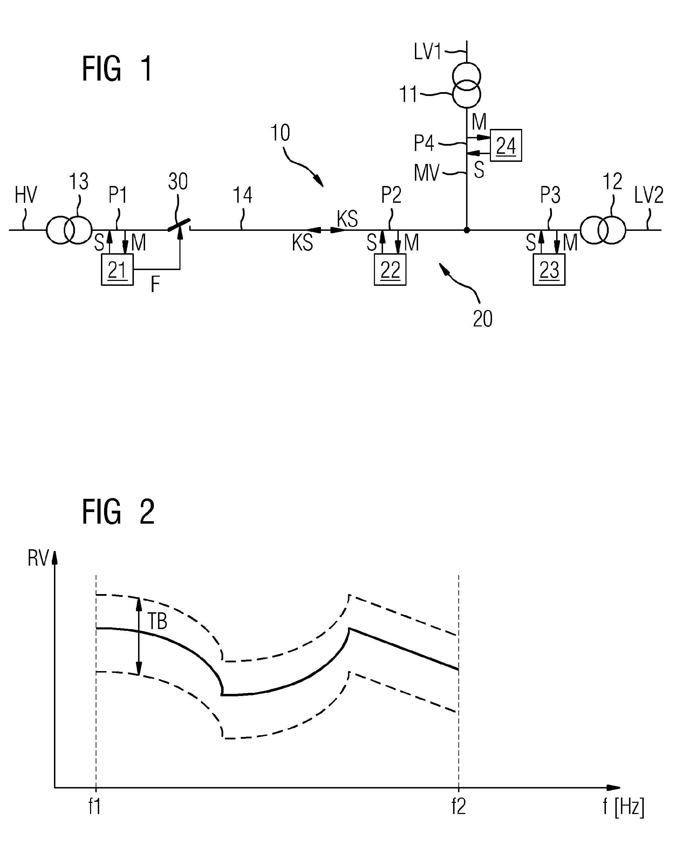

Die Figur 1 zeigt ein Ausführungsbeispiel für ein Energieverteilnetz 10, von dem in der Figur 1 ein Mittelspannungsbereich MV, ein Hochspannungsbereich HV sowie zwei Niederspannungsbereiche LV1 und LV2 dargestellt sind.

Die beiden Niederspannungsbereiche LV1 und LV2 sind über jeweils einen Transformator 11 bzw. 12 an den Mittelspannungsbereich MV angeschlossen. Der Mittelspannungsbereich MV steht mit dem Hochspannungsbereich HV über einen Transformator 13 in Verbindung.

An einer ersten Stelle P1 ist eine erste Überwachungseinrichtung 21 einer mehrere Überwachungseinrichtungen 21 bis 24 aufweisenden Überwachungsanordnung 20 an den Mittelspannungsbereich MV des Energieverteilnetzes 10 angeschlossen. Eine zweite Überwachungseinrichtung 22 ist an einer zweiten Stelle P2 mit dem Mittelspannungsbereich MV des Energieverteilnetzes 10 verbunden, und eine dritte und eine vierte Überwachungseinrichtung 23 und 24 stehen an einer dritten Stelle P3 bzw. an einer vierten Stelle P4 mit dem Mittelspannungsbereich MV des Energieverteilnetzes 10 in Verbindung.

Die erste Überwachungseinrichtung 21 und die zweite Überwachungseinrichtung 22 schließen eine Energieübertragungsleitung 14 des Mittelspannungsbereichs MV zwischen sich ein; diese Energieübertragungsleitung 14 ist mit einem Schalter 30 ausgestattet, der ein Abschalten der Energieübertragungsleitung 14 und damit ein elektrisches Abtrennen des Mittelspannungsbereichs MV sowie der Niederspannungsbereiche LV1 und LV2 von dem Hochspannungsbereich HV ermöglicht.

Die Überwachungsanordnung 20 kann zum Schutz des Energieverteilnetzes 10, insbesondere des Mittelspannungsbereichs MV des Energieverteilnetzes 10, beispielsweise wie folgt betrieben werden:
Die erste Überwachungseinrichtung 21 speist mittels einer in der Figur 1 aus Gründen der Übersicht nicht weiter dargestellten Messsignalerzeugungseinheit ein elektrisches Messsignal S mit einer nicht-netzfrequenten Frequenz, also einer Frequenz, die sich von der Netzfrequenz des Energieverteilnetzes 10, insbesondere des Mittelspannungsbereichs MV, unterscheidet, an der ersten Stelle P1 in das Energieverteilnetz 10 ein.

An der ersten Stelle P1 misst die erste Überwachungseinrichtung 21 mit einer aus Gründen der Übersicht in der Figur 1 ebenfalls nicht gezeigten Messeinrichtung eine auf die jeweilige nicht-netzfrequente Frequenz des Messsignals S bezogene elektrische Messgröße M unter Bildung eines Messwerts.

Besonders vorteilhaft ist es, wenn während der Messung durch die Messeinrichtung der Überwachungseinrichtung 21 die Frequenz des Messsignals S von der Messsignalerzeugungseinheit innerhalb eines vorgegebenen nicht-netzfrequenten Frequenzbands durchfahren wird; ein solches Durchfahren des Frequenzbands ermöglicht es der Messeinrichtung der ersten Überwachungseinrichtung 21, die elektrische Messgröße M unter Bildung eines frequenzbandbezogenen Messwertverlaufs zu messen.

Die erste Überwachungseinrichtung 21 wird den frequenzbandbezogenen Messwertverlauf auswerten und ein Fehlersignal F erzeugen, wenn der frequenzbandbezogene Messwertverlauf auf einen Fehler in dem Energieverteilnetz 10, insbesondere der Energieübertragungsleitung 14, hindeutet. Die Überprüfung des frequenzbandbezogenen Messwertverlaufs mit Blick auf einen etwaigen Fehler wird vorzugsweise anhand eines Referenzverlaufs RV (vgl. Figur 2) durchgeführt, der durch Messen der Messgröße M in dem nicht-netzfrequenten Frequenzband zu einem Zeitpunkt bzw. in einem Zeitfenster aufgenommen worden ist, der bzw. das als fehlerfrei angenommen wird bzw. tatsächlich fehlerfrei war.

Als Referenzverlauf RV kann in vorteilhafter Weise der Impedanzverlauf in dem Frequenzband gebildet werden. Bei dieser Ausgestaltung wird mit dem aktuellen frequenzbandbezogenen Messwertverlauf als Vergleichswertverlauf vorzugsweise der aktuelle Impedanzverlauf in dem Frequenzband ermittelt.

In der Figur 2 ist ein Ausführungsbeispiel für einen Referenzverlauf RV über der Frequenz f dargestellt. Das nicht-netzfrequente Frequenzband, für das der Referenzverlauf RV erzeugt worden ist, erstreckt sich bei dem Ausführungsbeispiel gemäß Figur 2 von einer unteren Frequenz f1 (z. B. f1 = 100 kHz) bis zu einer oberen Frequenz f2 (z. B. f2 = 500 kHz).

Die erste Überwachungseinrichtung 21 wird das Fehlersignal F beispielsweise erzeugen, wenn der aktuelle frequenzbandbezogene Messwertverlauf oder ein mit diesem gebildeter Vergleichswertverlauf (z. B. der aktuelle Wellenwiderstands- oder Dämpfungsverlauf) vom Referenzverlauf RV über ein vorgegebenes Maß hinaus abweicht. In der Figur 2 ist beispielhaft ein Toleranzband TB eingezeichnet, das ein tolerables Maß an Abweichungen vom Referenzverlauf RV darstellt.

Als elektrisches Messsignal S kann die erste Überwachungseinrichtung 21 eine elektrische Spannung an der ersten Stelle P1 in das Energieverteilnetz 10 einspeisen; dabei wird sie - wie oben erläutert - vorzugsweise die Frequenz der Spannung innerhalb des in der Figur 2 beispielhaft gezeigten nicht-netzfrequenten Frequenzbands zwischen der unteren Frequenz f1 und der oberen Frequenz f2 durchfahren.

Als Messgröße M kann die erste Überwachungseinrichtung 21 beispielsweise den Strom nach Betrag und/oder Phase für das nicht-netzfrequente Frequenzband messen und den jeweils aktuell gemessenen Stromverlauf nach Betrag und/oder Phase mit dem vorab ermittelten Referenzverlauf RV - wiederum nach Betrag und/oder Phase - für den Strom vergleichen und/oder mit dem Stromverlauf nach Betrag und/oder Phase (sowie dem korrespondierenden Spannungsverlauf) als Vergleichswertverlauf einen Impedanzverlauf ermitteln, der nachfolgend dem Vergleich zugrunde gelegt wird. Der Vergleich kann unter Heranziehung üblicher mathematischer Verfahren erfolgen, wie zum Beispiel auf der Basis von Kreuzkorrelationsfunktionen, von Mustererkennung, durch (linear oder nichtlinear gewichtete) Aufsummierung oder Integration von Abweichungswerten über dem Verlauf usw., und insbesondere auch auf der Basis von neuronalen Netzen auf der Basis einer modellgestützten (Ersatzmodell des elektrischen Netzes) Zustandsschätzung.

Liegt der aktuell gemessene Stromverlauf nach Betrag und/oder Phase bzw. der aktuelle Vergleichswertverlauf innerhalb des Toleranzbands TB für den Referenzverlauf RV in Figur 2, so wird die Überwachungseinrichtung 21 davon ausgehen, dass kein Fehler in dem Energieverteilnetz 10 bzw. auf der Energieübertragungsleitung 14 aufgetreten ist und auf die Erzeugung eines Fehlersignals F verzichten.

Stellt die erste Überwachungseinrichtung 21 hingegen fest, dass der aktuell gemessene Strom nach Betrag und/oder Phase bzw. der aktuelle Vergleichswertverlauf von dem Referenzverlauf RV gemäß Figur 2 über das Toleranzband TB hinaus abweicht, so wird sie auf einen Fehler schließen und das Fehlersignal F erzeugen.

Das Fehlersignal F kann beispielsweise als Schaltsignal für den Schalter 30 dienen, der bei Vorliegen des Fehlersignals F öffnet und die Energieübertragungsleitung 14 vom Hochspannungsbereich HV bzw. vom Transformator 13 trennt.

Die an den Stellen P2, P3 und P4 angeschlossenen Überwachungseinrichtungen 22, 23 und 24 können in analoger Weise bzw. genauso wie die erste Überwachungseinrichtung 21 betrieben werden. Mit anderen Worten können sie auch selbständig ein elektrisches Messsignal S einspeisen und eine elektrische Messgröße M messen und in Abhängigkeit von der gemessenen Messgröße M auf einen Fehler schließen. Die Messsignale S der an den Stellen P1, P2, P3 und P4 angeschlossenen Überwachungseinrichtungen 21, 22, 23 und 24 unterscheiden sich mit Blick auf eine Unterscheidung der Signale vorzugsweise im Zeit-Frequenz-Bereich.

Um zu vermeiden, dass die Überwachungseinrichtungen 21 bis 24 zu beliebigen Zeitpunkten elektrische Messsignale einspeisen und sich gegenseitig stören und es dadurch zu einer Verfälschung der Messergebnisse kommt, wird es als vorteilhaft angesehen, wenn sich die Überwachungseinrichtungen 21 bis 24 untereinander synchronisieren. Ein solches Synchronisieren erfolgt vorzugsweise über Kommunikationssignale KS, die über ein separates Kommunikationsnetz oder besonders bevorzugt über das Energieverteilnetz 10 übertragen werden. Bezüglich der Übertragung der Kommunikationssignale KS über das Energieverteilnetz 10 kann auf bekannte Kommunikationstechniken zurückgegriffen werden, wie sie beispielsweise unter dem Fachbegriff Power-Line-Carrier-Technologie bekannt sind.

Mit Blick auf den Betrieb der Überwachungsanordnung 20 wird es als besonders vorteilhaft angesehen, wenn eine der Überwachungseinrichtungen 21 bis 24, beispielsweise die erste Überwachungseinrichtung 21, als zentrale Schutzeinrichtung bzw. Master-Einrichtung fungiert, mit der die übrigen Überwachungseinrichtungen 22 bis 24 als Slave-Einrichtungen in Verbindung stehen, beispielsweise über die bereits erwähnten Kommunikationssignale KS. Mittels der Kommunikationssignale KS können die Überwachungseinrichtungen 22 bis 24 die von ihnen aufgenommenen Messwerte oder Messwertverläufe, Vergleichswerte oder Vergleichswertverläufe oder ggf. bereits überwachungseinrichtungsindividuell erzeugte Hilfsfehlersignale zu der als zentrale Schutzeinrichtung fungierenden ersten Überwachungseinrichtung 21 übertragen, die nachfolgend die Auswertung der erhaltenen Messwertverläufe oder Vergleichswertverläufe vornimmt und/oder im Falle eines Empfangs eines überwachungseinrichtungsindividuell erzeugten Hilfsfehlersignals ein zentrales Fehlersignal F zum Ausschalten des Schalters 30 erzeugt.

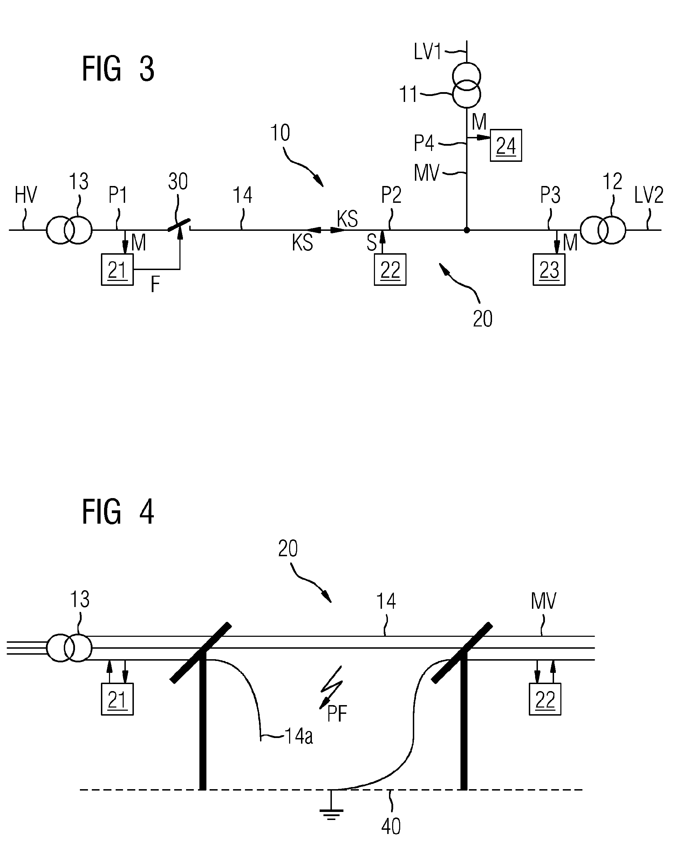

Im Zusammenhang mit einem möglichen Betriebsverfahren der Überwachungsanordnung 20 gemäß Figur 1 wurde oben beispielhaft davon ausgegangen, dass jede der Überwachungseinrichtungen 21 bis 24 jeweils selbst elektrische Messsignale S erzeugt und in das Energieverteilnetz einspeist und auf das selbst eingespeiste Messsignal S bezogene Messwerte oder Messwertverläufe aufnimmt. Alternativ ist es möglich, das Einspeisen von Messsignalen S und das Erfassen von Messgrößen M an unterschiedlichen Stellen P1 bis P4 des Energieverteilnetzes 10 durchzuführen. Dies soll nachfolgend beispielhaft anhand der Figur 3 näher erläutert werden:
Bei der Darstellung gemäß Figur 3 wird beispielhaft davon ausgegangen, dass die zweite Überwachungseinrichtung 22 an der zweiten Stelle P2 ein Messsignal S in das Energieverteilnetz 10 bzw. die Energieübertragungsleitung 14 einspeist. Das Einspeisen des Messsignals S erfolgt vorzugsweise derart, dass die Frequenz des Messsignals S innerhalb eines vorgegebenen nicht-netzfrequenten Frequenzbands, beispielsweise dem Frequenzband zwischen der unteren Frequenz f1 und der oberen Frequenz f2 gemäß Figur 2, durchfahren wird.

Synchronisiert zu dem Messsignal S - vorzugsweise durch ein Kommunikationssignal KS - kann die erste Überwachungseinrichtung 21 die Messgröße M für das nicht-netzfrequente Frequenzband messen und einen frequenzbandbezogenen Messwertverlauf messen, der sich auf das Messsignal S der zweiten Überwachungseinrichtung 22 bezieht. Nachfolgend kann die erste Überwachungseinrichtung 21 den frequenzbandbezogenen Messwertverlauf mit einem Referenzverlauf RV (siehe Figur 2) vergleichen, den sie vorab für einen als fehlerfrei angenommenen Zeitpunkt bei einer Einspeisung des Messsignals S durch die zweite Überwachungseinrichtung 22 aufgenommen hat. Stellt die erste Überwachungseinrichtung 21 fest, dass der aktuell aufgenommene frequenzbandbezogene Messwertverlauf oder der aktuelle Vergleichswertverlauf über ein vorgegebenes Maß vom Referenzverlauf RV abweicht, so erzeugt sie das Fehlersignal F, wie dies bereits oben im Zusammenhang mit den Figuren 1 bis 2 erläutert worden ist.

In entsprechender Weise kann die erste Überwachungseinrichtung 21 mit der dritten Überwachungseinrichtung 23 und der vierten Überwachungseinrichtung 24 kooperieren und Messgrößen aufnehmen, die sich auf Messsignale beziehen, die von der dritten bzw. vierten Überwachungseinrichtung 23 bzw. 24 eingespeist worden sind.

Darüber hinaus ist es möglich, Einspeisestellen und Messstellen zu vertauschen. So kann beispielsweise die erste Überwachungseinrichtung 21 zum Einspeisen des elektrischen Messsignals S dienen, und die übrigen Überwachungseinrichtungen 22 bis 24 nehmen Messwerte oder frequenzbandbezogene Messwertverläufe auf, wie dies oben erläutert worden ist. Bei der letztgenannten Fallgestaltung ist es vorteilhaft, wenn die Überwachungseinrichtungen 22 bis 24 die Messwerte bzw. Messwertverläufe jeweils selbst auswerten und ein überwachungseinrichtungsindividuelles Hilfsfehlersignal erzeugen, wenn aktuell gemessene Messwertverläufe oder damit gebildete aktuelle Vergleichswertverläufe von abgespeicherten Referenzverläufen RV über ein vorgegebenes Maß abweichen. Die überwachungseinrichtungsindividuell erzeugten Hilfsfehlersignale werden vorzugsweise zu der als zentrale Schutzeinrichtung fungierenden ersten Überwachungseinrichtung 21 übertragen, die nachfolgend das zentrale Fehlersignal F zum Ausschalten des Schalters 30 erzeugen kann.

Auch ist es möglich, dass stets alle anderen Überwachungseinrichtungen Messgrößen M erfassen, wenn eine der Überwachungseinrichtungen aktiv ein Messsignal S einspeist: Beispielsweise können die Überwachungseinrichtungen 23 und 24 parallel zu der ersten Überwachungseinrichtung Messungen vornehmen und ggf. ein überwachungseinrichtungsindividuelles Hilfsfehlersignal erzeugen, wenn die zweite Überwachungseinrichtung das Messsignal S erzeugt (siehe Figur 3). Entsprechendes gilt für ein Einspeisen eines Messsignals durch die erste, dritte oder vierte Überwachungseinrichtung 21, 23 bzw. 24.

Bei der Aufnahme der Referenzverläufe und der Messung der aktuellen Messwertverläufe kann die Frequenz des Messsignals S durch das nicht-netzfrequente Frequenzband hindurchgefahren werden, so dass die verschiedenen Frequenzen zeitlich nacheinander erzeugt werden. Alternativ ist es möglich, ein breitbandiges Messsignal S zu erzeugen, das das gesamte nicht-netzfrequente Frequenzband (oder Abschnitte davon) während der Messung gleichzeitig abdeckt; im letztgenannten Fall wird die Messgröße vorzugsweise frequenzselektiv mittels Filterung gemessen oder zumindest frequenzselektiv ausgewertet.

Die Figur 4 zeigt beispielhaft einen hochohmigen Fehler an einer Fehlerstelle PF im Mittelspannungsbereich MV des Energieverteilnetzes 10 gemäß den Figuren 1 und 3 näher im Detail. Es lässt sich erkennen, dass ein Phasenleiter 14a der dreiphasigen Energieübertragungsleitung 14 gerissen ist und einen Erdkontakt zur Erde 40 hergestellt hat. Handelt es sich bei dem Mittelspannungsbereich MV um ein Mittelspannungsnetz mit starrer Sternpunkterdung, so ist ein solcher Fehler (vgl. zum Beispiel die Überwachungseinrichtung 21 in Figur 4) im Allgemeinen hochohmig und nur schwer erkennbar. Aufgrund der oben im Zusammenhang mit den Figuren 1 bis 3 erläuterten Vorgehensweise bei der Fehlerdetektion, konkret aufgrund des Einspeisens eines nicht-netzfrequenten Messsignals und des Aufnehmens einer nicht-netzfrequenten Messgröße, ist es insbesondere für diejenigen Überwachungseinrichtungen, die nahe an der Fehlerstelle PF liegen - wie beispielsweise die erste Überwachungseinrichtung 21 und/oder die zweite Überwachungseinrichtung 22 -, zuverlässig möglich, Fehler zu erkennen.

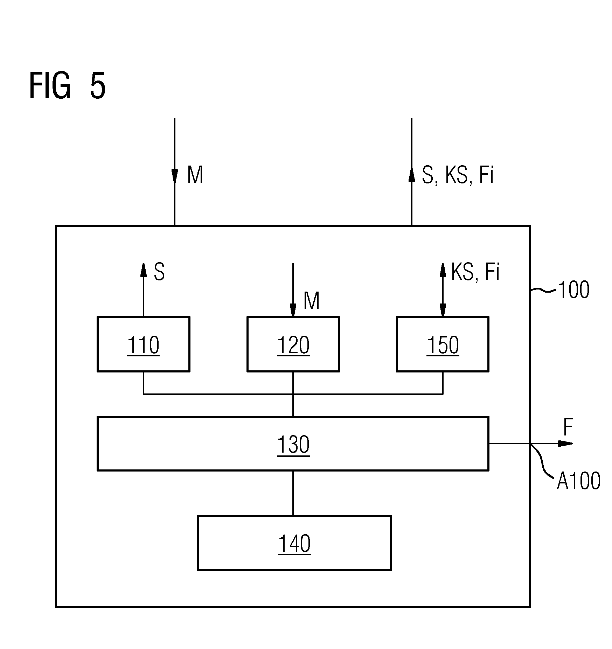

Die Figur 5 zeigt ein Ausführungsbeispiel für eine Überwachungseinrichtung 100, die als eine der Überwachungseinrichtungen 21 bis 24 der Überwachungsanordnung 20 gemäß den Figuren 1 bis 4 eingesetzt werden kann.

Es lässt sich erkennen, dass die Überwachungseinrichtung 100 eine Messsignalerzeugungseinrichtung 110 aufweist, die ein elektrisches Messsignal S mit zumindest einer nicht-netzfrequenten Frequenz oder einem nicht-netzfrequenten Frequenzband an einer vorgegebenen Stelle einer Energieübertragungseinrichtung, also beispielsweise des Energieverteilnetzes 10 bzw. der Energieübertragungsleitung 14 gemäß den Figuren 1 bis 4 einspeisen kann.

Die Überwachungseinrichtung 100 weist darüber hinaus eine Messeinrichtung 120 auf, die eine elektrische Messgröße M unter Bildung zumindest eines Messwerts oder frequenzbandbezogenen Messwertverlaufs messen kann.

Mit der Messsignalerzeugungseinrichtung 110 und der Messeinrichtung 120 steht eine Auswerteinrichtung 130 in Verbindung, die die Messsignalerzeugungseinrichtung ansteuert und die Messergebnisse der Messeinrichtung 120 beispielsweise unter Bildung von aktuellen Vergleichswertverläufen auswertet.

Mit der Auswerteinrichtung 130 ist vorzugsweise ein Speicher 140 verbunden, in dem Referenzwerte oder Referenzverläufe RV gespeichert sind, die zu Zeitpunkten gemessen worden sind, die als fehlerfrei angenommen werden. Anhand von Referenzwerten oder Referenzverläufen kann die Auswerteinrichtung 130 ein Fehlersignal F (beispielsweise, wenn sie als Master-Einrichtung arbeitet) oder ein überwachungseinrichtungsindividuelles Hilfsfehlersignal Fi (beispielsweise, wenn sie als Slave-Einrichtung arbeitet) erzeugen, wenn sie bei einem Vergleich von aktuell aufgenommenen Messwerten bzw. Messwertverläufen bzw. aktuellen Vergleichswertwerten oder aktuellen Vergleichswertverläufen mit den abgespeicherten Referenzwerten oder abgespeicherten Referenzverläufen auf einen Fehler schließt.

Die Überwachungseinrichtung 100 weist darüber hinaus vorzugsweise eine Kommunikationseinrichtung 150 auf, die eine Kommunikation mit anderen Überwachungseinrichtungen und/oder einer zentralen Schutzeinrichtung ermöglicht. Die Kommunikationseinrichtung 150 ist vorzugsweise geeignet, mittels Kommunikationssignalen KS Messwerte oder Messwertverläufe und/oder überwachungseinrichtungsindividuell erzeugte Hilfsfehlersignale Fi auszugeben. Arbeitet die Überwachungseinrichtung 100 als zentrale Schutzeinrichtung, so gibt sie Fehlersignale F vorzugsweise an einem separaten Fehlersignalausgang A100 aus.

Die Messsignalerzeugungseinheit 110, die Messeinrichtung 120 sowie die Auswerteinrichtung 130 können durch Softwaremodule einer Datenverarbeitungseinrichtung gebildet sein, die vorzugsweise einen oder mehrere Mikroprozessoren umfasst.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 10: Energieverteilnetz
- 11: Transformator
- 12: Transformator
- 13: Transformator
- 14: Energieübertragungsleitung
- 14a: Phasenleiter
- 20: Überwachungsanordnung
- 21: Überwachungseinrichtung
- 22: Überwachungseinrichtung
- 23: Überwachungseinrichtung
- 24: Überwachungseinrichtung
- 30: Schalter
- 40: Erde
- 100: Überwachungseinrichtung
- 110: Messsignalerzeugungseinrichtung
- 120: Messeinrichtung
- 130: Auswerteinrichtung
- 140: Speicher
- 150: Kommunikationseinrichtung

- A100: Fehlersignalausgang
- F: Fehlersignal
- Fi: Hilfsfehlersignal
- f: Frequenz
- f1: untere Frequenz
- f2: obere Frequenz
- HV: Hochspannungsbereich
- KS: Kommunikationssignale
- LV1: Niederspannungsbereich
- LV2: Niederspannungsbereich
- M: Messgröße
- MV: Mittelspannungsbereich
- PF: Fehlerstelle
- P1: Stelle
- P2: Stelle
- P3: Stelle
- P4: Stelle
- PF: Fehlerstelle
- RV: Referenzverlauf
- S: Messsignal
- TB: Toleranzband

## Patentansprüche

1. Verfahren zum Überwachen einer Energieübertragungseinrichtung, insbesondere einer Energieübertragungsleitung (14) oder eines Energieverteilnetzes (10), über die oder das elektrischer Strom mit einer vorgegebenen Netzfrequenz übertragen wird,
**dadurch gekennzeichnet, dass**
- ein elektrisches Messsignal (S) mit zumindest einer nicht-netzfrequenten Frequenz, also einer Frequenz, die sich von der Netzfrequenz unterscheidet, oder einem nicht-netzfrequenten Frequenzband an einer vorgegebenen Stelle (P1-P4) der Energieübertragungseinrichtung in diese eingespeist wird,
- an der vorgegebenen Stelle (P1-P4) oder einer anderen Stelle (P1-P4) der Energieübertragungseinrichtung eine auf die nicht-netzfrequente Frequenz oder das nicht-netzfrequente Frequenzband bezogene elektrische Messgröße (M) unter Bildung zumindest eines Messwerts oder frequenzbandbezogenen Messwertverlaufs gemessen wird und
- ein Fehlersignal (F) erzeugt wird, wenn der Messwert, der frequenzbandbezogene Messwertverlauf, ein mit dem Messwert oder dem Messwertverlauf gebildeter Vergleichswert oder Vergleichswertverlauf auf einen Fehler in der Energieübertragungseinrichtung hindeutet.

2. Verfahren nach Anspruch 1,
**dadurch gekennzeichnet, dass**
- der Messwert oder der frequenzbandbezogene Messwertverlauf unter Bildung eines Referenzwertes oder Referenzverlaufs (RV) zu einem Zeitpunkt erfasst wird, der als fehlerfrei angenommen wird, und
- ein Fehlersignal (F) erzeugt wird, wenn der aktuelle Messwert oder der aktuelle frequenzbandbezogene Messwertverlauf oder ein mit dem aktuellen Messwert oder dem aktuellen frequenzbandbezogenen Messwertverlauf gebildeter aktueller Vergleichswert oder aktueller Vergleichswertverlauf über ein vorgegebenes Maß vom Referenzwert oder Referenzverlauf (RV) abweicht.

3. Verfahren nach einem der voranstehenden Ansprüche,
**dadurch gekennzeichnet, dass**
- an der vorgegebenen Stelle (P1-P4) als elektrisches Messsignal (S) eine elektrische Spannung mit nicht-netzfrequenter Frequenz eingespeist wird und
- an derselben Stelle (P1-P4) als die nicht-netzfrequente Messgröße (M) der Strom nach Betrag und/oder Phase gemessen wird.

4. Verfahren nach Anspruch 3,
**dadurch gekennzeichnet, dass**
- während der Messung die Frequenz der Spannung innerhalb eines vorgegebenen nicht-netzfrequenten Frequenzbands durchfahren wird und
- der Strom nach Betrag und/oder Phase für das Frequenzband gemessen wird.

5. Verfahren nach einem der voranstehenden Ansprüche,
**dadurch gekennzeichnet, dass**
- als Referenzwert oder Referenzverlauf (RV) die Leitungsimpedanz, der Leitungsimpedanzverlauf, der Wellenwiderstand, der Wellenwiderstandsverlauf in dem Frequenzband, die Dämpfung der Energieübertragungseinrichtung oder der Dämpfungsverlauf der Energieübertragungseinrichtung in dem Frequenzband zu dem als fehlerfrei angenommenen Zeitpunkt gebildet wird und
- mit dem aktuellen Messwert oder dem aktuellen frequenzbandbezogenen Messwertverlauf als Vergleichswert oder Vergleichswertverlauf die aktuelle Leitungsimpedanz, der aktuelle Leitungsimpedanzverlauf, der aktuelle Wellenwiderstand, der aktuelle Wellenwiderstandsverlauf in dem Frequenzband, die aktuelle Dämpfung der Energieübertragungseinrichtung oder der Dämpfungsverlauf der Energieübertragungseinrichtung in dem Frequenzband ermittelt wird.

6. Verfahren nach einem der voranstehenden Ansprüche,
**dadurch gekennzeichnet, dass**
- mit einer ersten Überwachungseinrichtung (21) das Messsignal (S) an der vorgegebenen Stelle der Energieübertragungseinrichtung, nachfolgend erste Stelle (P1) genannt, eingespeist wird und
- mit einer zweiten Überwachungseinrichtung (22) an einer anderen Stelle der Energieübertragungseinrichtung, nachfolgend zweite Stelle (P2) genannt, der Messwert oder Messwertverlauf gemessen wird.

7. Verfahren nach Anspruch 6,
**dadurch gekennzeichnet, dass** die erste und zweite Überwachungseinrichtung (21-22) in einer Kommunikationsverbindung, die insbesondere auf über die Energieübertragungseinrichtung übermittelten nicht-netzfrequenten Kommunikationssignalen (KS) und/oder auf Messsignalen, die zusätzlich als Kommunikationssignale dienen, beruht, stehen und das Einspeisen des Messsignals (S) und das Erfassen des Messwerts oder Messwertverlaufs über die Kommunikationsverbindung synchronisiert wird.

8. Verfahren nach einem der voranstehenden Ansprüche 6 bis 7,
**dadurch gekennzeichnet, dass**
- der Messwert, Messwertverlauf, Vergleichswert und/oder Vergleichswertverlauf von der zweiten Überwachungseinrichtung (22) zu der ersten Überwachungseinrichtung (21) übertragen wird, insbesondere über die Energieübertragungseinrichtung mittels eines nicht-netzfrequenten Kommunikationssignals (KS), und
- die erste Überwachungseinrichtung (21) das Fehlersignal (F) erzeugt, wenn der Messwert, Messwertverlauf, Vergleichswert oder Vergleichswertverlauf auf einen Fehler in der Energieübertragungseinrichtung hindeutet.

9. Verfahren nach einem der voranstehenden Ansprüche,
**dadurch gekennzeichnet, dass**
- an die Energieübertragungseinrichtung an verschiedenen Stellen zwei oder mehr Überwachungseinrichtungen (21-24) angeschlossen sind, mit denen jeweils nicht-netzfrequente Messsignale in die Energieübertragungseinrichtung eingespeist und/oder nicht-netzfrequente Messwerte oder Messwertverläufe erfasst werden und/oder aktuelle Vergleichswerte oder aktuelle Vergleichswertverläufe gebildet werden und/oder überwachungseinrichtungsindividuell Hilfsfehlersignale (Fi) erzeugt werden,
- die Messwerte, die Messwertverläufe, die aktuellen Vergleichswerte, die aktuellen Vergleichswertverläufe und/oder die überwachungseinrichtungsindividuell erzeugten Hilfsfehlersignale (Fi) zu einer zentralen Schutzeinrichtung übertragen werden und
- die zentrale Schutzeinrichtung das Fehlersignal (F) erzeugt, wenn einer oder mehrere der Messwerte oder einer oder mehrere der Messwertverläufe oder einer oder mehrere der aktuellen Vergleichswerte oder einer oder mehrere der aktuellen Vergleichswertverläufe auf einen Fehler in der Energieübertragungseinrichtung hindeuten.

10. Verfahren nach einem der voranstehenden Ansprüche,
**dadurch gekennzeichnet, dass** die nicht-netzfrequente Frequenz des elektrisches Messsignals (S) oder das nicht-netzfrequente Frequenzband in einem Frequenzbereich zwischen 30 kHz und 30 MHz, insbesondere zwischen 100 kHz und 500 kHz, liegt.

11. Verfahren nach einem der voranstehenden Ansprüche,
**dadurch gekennzeichnet, dass** mit dem Verfahren ein Spannungsnetz, insbesondere ein Mittelspannungsnetz, mit starrer Sternpunkterdung überwacht wird.

12. Überwachungseinrichtung (21-24) zum Überwachen einer Energieübertragungseinrichtung, insbesondere einer Energieübertragungsleitung (14) oder eines Energieverteilnetzes (10), über die oder das elektrischer Strom mit einer vorgegebenen Netzfrequenz übertragen wird,
**dadurch gekennzeichnet, dass**
- die Überwachungseinrichtung (21-24) eine Messeinrichtung (120) aufweist, die eine auf eine nicht-netzfrequente Frequenz oder ein nicht-netzfrequentes Frequenzband bezogene elektrische Messgröße (M) unter Bildung zumindest eines Messwerts oder frequenzbandbezogenen Messwertverlaufs messen kann und
- die Überwachungseinrichtung (21-24) eine Auswerteinrichtung (130) aufweist, die ein Fehlersignal (F) erzeugt, wenn der Messwert, der frequenzbandbezogene Messwertverlauf, ein mit dem Messwert oder dem Messwertverlauf gebildeter Vergleichswert oder Vergleichswertverlauf auf einen Fehler in der Energieübertragungseinrichtung hindeutet.

13. Überwachungsanordnung (20) zum Überwachen einer Energieübertragungseinrichtung, insbesondere einer Energieübertragungsleitung (14) oder eines Energieverteilnetzes (10), über die oder das elektrischer Strom mit einer vorgegebenen Netzfrequenz übertragen wird,
**dadurch gekennzeichnet, dass** die Überwachungsanordnung (20) zumindest eine Überwachungseinrichtung (21-24) nach Anspruch 12 und zumindest eine Messsignalerzeugungseinheit (110) aufweist, die ein elektrisches Messsignal (S) mit zumindest einer nicht-netzfrequenten Frequenz oder einem nicht-netzfrequenten Frequenzband in die Energieübertragungseinrichtung einspeisen kann.

14. Überwachungsanordnung (20) nach Anspruch 13,
**dadurch gekennzeichnet, dass**
- die Überwachungsanordnung (20) eine zentrale Schutzeinrichtung (21) aufweist, mit der die zumindest eine Überwachungseinrichtung (22-24) in Verbindung steht und zu der die Messwerte, Messwertverläufe, Vergleichswerte oder Vergleichswertverläufe oder überwachungseinrichtungsindividuell erzeugte Hilfsfehlersignale (Fi) übertragen werden, und
- die zentrale Schutzeinrichtung derart ausgestaltet ist, dass sie das Fehlersignal (F) erzeugt, wenn einer oder mehrere der Messwerte, Messwertverläufe, Vergleichswerte oder Vergleichswertverläufe auf einen Fehler in der Energieübertragungseinrichtung hindeuten oder ein überwachungseinrichtungsindividuell erzeugtes Hilfsfehlersignal (Fi) empfangen wird.

15. Energieübertragungseinrichtung,
**dadurch gekennzeichnet, dass**
- die Energieübertragungseinrichtung ein Mittelspannungsnetz mit starrer Sternpunkterdung, ein Mittelspannungsbereich (MV) eines Energieverteilnetzes (10) mit starrer Sternpunkterdung oder eine Mittelspannungsenergieübertragungsleitung mit starrer Sternpunkterdung ist, und
- an die Energieübertragungseinrichtung zumindest eine Überwachungseinrichtung (21-24) nach Anspruch 12 und/oder eine Überwachungsanordnung (20) nach Anspruch 13 oder 14 angeschlossen ist und die Energieübertragungseinrichtung mit der Überwachungseinrichtung (21-24) und/oder der Überwachungsanordnung (20) nach einem Verfahren nach einem der Ansprüche 1 bis 11 überwacht wird.
